# EUROPÄISCHE PATENTANMELDUNG

(11) **EP 4 672 206 A1**
(43) Veröffentlichungstag der Anmeldung: **31.12.2025**
(21) Anmeldenummer: 25185504.5
(22) Anmeldetag: 26.06.2025
(51) Int. Cl.: G09F 9/00

(54) **ANZEIGE ZUM ANZEIGEN VON INFORMATIONEN**

(30) Priorität: 26.06.2024 DE 102024118033
(71) Anmelder: Bremicker Verkehrstechnik GmbH, 82362 Weilheim (DE)
(72) Erfinder: Dopfer, Herbert, 82380 Peissenberg (DE)
(74) Vertreter: Baldus, Oliver

(57) **Zusammenfassung**

Anzeige (100) zum Anzeigen von Bildern oder Informationen, mit einer Mehrzahl von Lichtquellen (103-1, ..., 103-n); und einem Optikelement (105) zum Lenken von Licht einer ersten Lichtquelle (103-1) in eine erste Richtung (107-1) und zum Lenken von Licht einer zweiten Lichtquelle (103-2) in eine zweite Richtung (107-2).

## Beschreibung

Die vorliegende Erfindung betrifft eine elektrisch angesteuerte Anzeige zur Wiedergabe von veränderlichen Informationen, wie beispielswese Bildern oder Zeichen.

Es ist die technische Aufgabe der vorliegenden Erfindung, eine Anzeige zur Wiedergabe von veränderlichen Informationen bereitzustellen, die die Informationen bedarfsweise in unterschiedlichen Richtungen anzeigen kann.

Diese technische Aufgabe wird durch Gegenstände nach den unabhängigen Ansprüchen gelöst. Technisch vorteilhafte Ausführungsformen sind Gegenstand der abhängigen Ansprüche, der Beschreibung und der Zeichnungen.

Gemäß einem ersten Aspekt wird die technische Aufgabe durch eine Anzeige zur Wiedergabe von veränderlichen Informationen gelöst, mit einer Mehrzahl von Lichtquellen; und einem Optikelement zum Lenken von Licht einer ersten Lichtquelle in eine erste Richtung und zum Lenken von Licht einer zweiten Lichtquelle in eine zweite Richtung. Die Lichtquellen können durch einzelne Leuchtmittel oder Lichtquellengruppen gebildet sein. Die Lichtquellen hinter dem Optikelement sind gegenseitig beabstandet. Durch die Anzeige wird der technische Vorteil erreicht, dass sich die Information oder das Bild je nach Aktivierung der ersten oder zweiten Lichtquelle bedarfsweise durch das Optikelement in unterschiedliche Richtungen projizieren lässt.

In einer technisch vorteilhaften Ausführungsform der Anzeige sind die Lichtquellen in einer Matrix angeordnet. Die Matrix kann eine zweidimensionale Matrix sein. Dadurch wird beispielsweise der technische Vorteil erreicht, dass das Bild oder die Information in einer Vielzahl von vertikalen und horizontalen Richtungen angezeigt werden kann.

In einer weiteren technisch vorteilhaften Ausführungsform der Anzeige sind die Lichtquellen durch Mikro-LEDs oder organische LEDs gebildet. Dadurch wird beispielsweise der technische Vorteil erreicht, dass die Lichtquellen nahe aneinander angeordnet sein können und Licht effizient erzeugen.

In einer weiteren technisch vorteilhaften Ausführungsform der Anzeige umfasst die Anzeige eine Mehrzahl von Optikelementen mit jeweils einer Mehrzahl von Lichtquellen. Dadurch wird beispielsweise der technische Vorteil erreicht, dass das Bild oder die Information mit hoher Auflösung angezeigt werden kann.

In einer weiteren technisch vorteilhaften Ausführungsform der Anzeige sind die Optikelemente matrixförmig angeordnet. Die Matrix kann eine zweidimensionale Matrix sein. Dadurch wird beispielsweise ebenfalls der technische Vorteil erreicht, dass das Bild oder die Information mit hoher Auflösung angezeigt werden kann.

In einer weiteren technisch vorteilhaften Ausführungsform der Anzeige sind die Lichtquellen ausgebildet, Licht unterschiedlicher Wellenlänge zu emittieren. Die Lichtquellen können jeweils unabhängig von den anderen eine entsprechende Farbe anzeigen. Dadurch wird beispielsweise der technische Vorteil erreicht, dass die Anzeige das Bild oder die Information farblich anzeigen kann.

In einer weiteren technisch vorteilhaften Ausführungsform der Anzeige umfasst das Optikelement eine Sammellinse, eine Freiformlinse und/oder ein Lichtleitelement. Dadurch wird beispielsweise der technische Vorteil erreicht, dass geeignete Bauteile zum Lenken des Lichts verwendet werden.

In einer weiteren technisch vorteilhaften Ausführungsform der Anzeige haben die Lichtquellen einen Abstand von weniger als 300 µm zueinander. Dadurch wird beispielsweise der technische Vorteil erreicht, dass sich eine hohe Winkelauflösung ergibt.

In einer weiteren technisch vorteilhaften Ausführungsform der Anzeige ist das Optikelement ausgebildet, Licht einer dritten Lichtquelle in eine dritte Richtung zu lenken. Dadurch wird beispielsweise der technische Vorteil erreicht, dass das Bild oder die Information in einer weiteren Richtung angezeigt werden kann.

In einer weiteren technisch vorteilhaften Ausführungsform der Anzeige sind die Lichtquellen auf einer Hintergrundplatte der Anzeige angeordnet. Dadurch wird beispielsweise der technische Vorteil erreicht, dass die Lichtquellen auf einfache Weise hinter den Optikelementen angeordnet werden können.

Gemäß einem zweiten Aspekt wird die technische Aufgabe durch ein Verfahren zum Anzeigen von Bildern oder Informationen gelöst, mit den Schritten eines Lenkens von Licht einer ersten Lichtquelle durch ein Optikelement in eine erste Richtung; und eines Lenkens von Licht einer zweiten Lichtquelle durch das Optikelement in eine zweite Richtung. Durch das Verfahren werden die gleichen technischen Vorteile wie durch die Anzeige nach dem ersten Aspekt gelöst.

Ausführungsbeispiele der Erfindung sind in den Zeichnungen dargestellt und werden im Folgenden näher beschrieben.

### Es zeigen:

- Fig. 1: eine schematische Ansicht einer Anzeige;
- Fig. 2: eine vergrößerte schematische Ansicht der Anzeige zum Anzeigen von Bildern oder Informationen;
- Fig. 3: eine weitere vergrößerte schematische Ansicht einer Anzeige zum Anzeigen von Bildern oder Informationen;
- Fig. 4: eine weitere vergrößerte schematische Ansicht einer Anzeige zum Anzeigen von Bildern oder Informationen;
- Fig. 5: eine weitere vergrößerte schematische Ansicht einer Anzeige zum Anzeigen von Bildern oder Informationen; und
- Fig. 6: eine weitere vergrößerte schematische Ansicht einer Anzeige zum Anzeigen von Bildern oder Informationen.

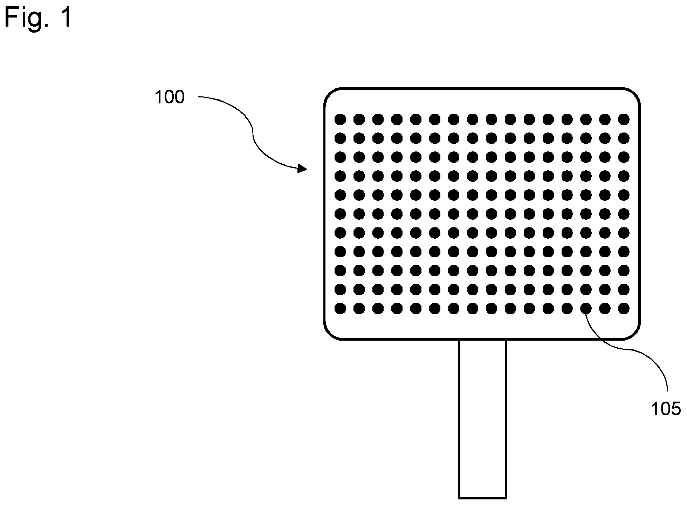

Fig. 1 zeigt eine schematische Ansicht einer Anzeige 100 zum Anzeigen von Bildern oder Informationen. Die Anzeige 100 zeigt Bilder oder Informationen für einen Benutzer optisch wahrnehmbar an. Die Anzeige 100 ist beispielsweise ein Monitor oder ein Display. Die Anzeige 100 kann für einen Computer, als Fernseher oder innerhalb einer Fahrzeugkonsole zum Anzeigen von Fahrzeuginformationen verwendet werden. Im Allgemeinen kann die Anzeige 100 aber auch in einer Vielzahl von anderen technischen Umgebungen eingesetzt werden, in denen Bilder und Informationen optisch wahrnehmbar angezeigt werden sollen.

Die Anzeige 100 umfasst hierzu eine Vielzahl von transparenten Optikelementen 105, die jeweils einen leuchtenden Bildpunkt des angezeigten Bildes bilden. Um das Bild oder die Information anzuzeigen, umfasst die Anzeige 100 eine matrixförmige Anordnung dieser Optikelemente 105. Durch entsprechende Aktivierung der jeweiligen Bildpunkte lassen sich alle möglichen Bilder oder Informationen flexibel farblich durch die Anzeige 100 darstellen. Die Anzeige 100 umfasst zu diesem Zweck eine elektronische Steuerung, mit der die einzelnen Bildpunkte unabhängig voneinander farblich und intensitätsmäßig gesteuert werden können.

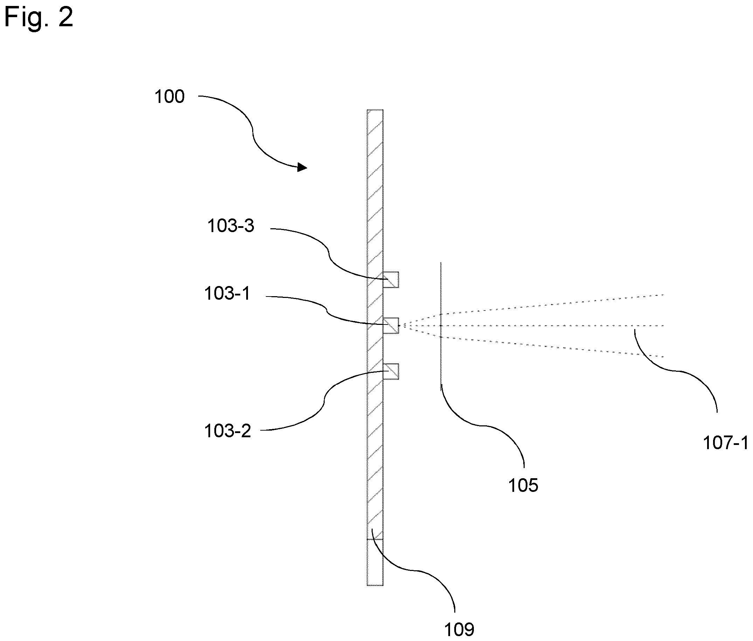

Fig. 2 zeigt eine vergrößerte schematische Ansicht der Anzeige 100 zum Anzeigen von Bildern oder Informationen. Jedem einzelnen Optikelement 105 eines Bildpunktes der Anzeige 100 ist wiederum eine Mehrzahl von räumlich getrennten Lichtquellen 103 zugeordnet, die sich auf einer ebenen Hintergrundplatte 109 hinter dem Optikelement 105 befinden. Das Optikelement 105 bündelt oder sammelt das Licht der Lichtquellen 103-1 bis 103-3 und leitet dieses je nach Position der Lichtquelle 103-1 bis 103-3 in unterschiedliche Richtungen weiter.

Das Optikelement 105 ist beispielsweise durch eine Sammellinse gebildet und befindet sich beispielsweise in einem Abstand zur Hintergrundplatte 109 mit den Lichtquellen 103-1 bis 103-3. Dabei ist das Optikelement 105 so ausgebildet, dass das Licht einer ersten Lichtquelle 103-1 in eine erste Richtung gelenkt wird und das Licht einer zweiten Lichtquelle 103-2 in eine zweite Richtung gelenkt wird. In Allgemeinen ist die Anzahl von Lichtquellen 103-1 bis 103-3, die einem Optikelement 105 als Bildpunkt zugeordnet sind beliebig. Das Optikelement 105 kann hierzu beispielsweise eine Sammellinse, eine Freiformlinse und/oder ein Lichtleitelement umfassen.

Die Lichtquellen 103 können durch einzelne Lichtquellen oder durch Lichtquellengruppen gebildet sein. Die Lichtquellen 103 können beispielsweise jeweils durch ein oder mehrere Leuchtdioden gebildet sein. Jede der Lichtquellen 103 ist unabhängig von den anderen Lichtquellen steuerbar. Durch die individuelle Steuerbarkeit können die Lichtquellen 103 unabhängig voneinander aktiviert werden oder in einer Intensität und Farbe unabhängig voneinander geändert werden. Durch eine entsprechende Ansteuerung der Lichtquellen 103 lässt sich dann das Bild oder die Information durch das Optikelement 105 in unterschiedliche Richtungen projizieren.

Die Lichtquellen 103 können auch durch Teilbereiche eines LED-Bildschirms (engl.: MicroLED) gebildet sein, der hinter dem Optikelement 105 angeordnet ist. Auf dem LED-Bildschirm können plankonvexe Sammellinsen als Optikelement 105 angeordnet sein.

LED-Bildschirme umfassen Leuchtdioden (LED) als selbstleuchtende Pixel. Dabei haben die Leuchtdioden beispielsweise eine Leuchtbreite kleiner als 50 µm oder eine Leuchtfläche kleiner als 0,003 mm². Durch die geringe Größe der LEDs können zahlreiche Lichtquellen 103 in matrixförmiger Anordnung (Array) hinter dem Optikelement 105 angeordnet werden. Durch den Teilbereich eines LED-Bildschirms können auch Lichtquellengruppen mit mehreren Leuchtdioden als Lichtquelle 103 für das Optikelement 105 verwendet werden. mehrere Teilbereiche können sich gegenseitig überlappen.

Eine erste Lichtquelle 103-1 kann beispielsweise durch einen ersten Teilbereich des LED-Bildschirms gebildet sein und eine zweite Lichtquelle 103-2 durch einen zweiten Teilbereich des LED-Bildschirms. Der erste und der zweite Teilbereich können sich gegenseitig überlappen und flexibel auf dem LED-Bildschirm angezeigt werden. Durch die Verwendung eines LED-Bildschirms als Lichtquelle 103-1 und 103-2 lässt sich die Intensität und Farbe (Rot/Grün/Blau) der Lichtquelle 103-1 und 103-2 auf einfache Weise steuern. Zudem lassen sich Lichtquellen 103-1 und 103-2 an unterschiedlichen Positionen des LED-Bildschirms erzeugen, so dass das Licht in eine Vielzahl von Richtungen gelenkt werden kann. Jede Leuchtdiode des LED-Bildschirms kann eine Lichtquelle 103 bilden, die an einer unterschiedlichen Position gegenüber dem Optikelement 105 angeordnet ist. Allerdings können auch mehrere Leuchtdioden des LED-Bildschirms zu einer einzigen Lichtquelle 103 zusammengefasst sein.

Da jede der einzelnen Lichtquellen 103 unabhängig von den anderen Lichtquellen 103 aktiviert werden kann, lässt sich das Bild oder die Information durch die Anzeige 100 in eine Vielzahl von Richtungen projizieren. Wird beispielsweise ausschließlich die Lichtquelle 103-1 der jeweiligen Optikelemente 105 aktiviert, wird das Bild oder die Information nur in einer Richtung 107-1 angezeigt. Dadurch kann das Bild oder die Information ausschließlich für einen bestimmten Benutzer in einem vorgesehenen Winkelbereich angezeigt werden. Ein Benutzer außerhalb dieses Winkelbereichs erkennt das angezeigte Bild oder die Information nicht.

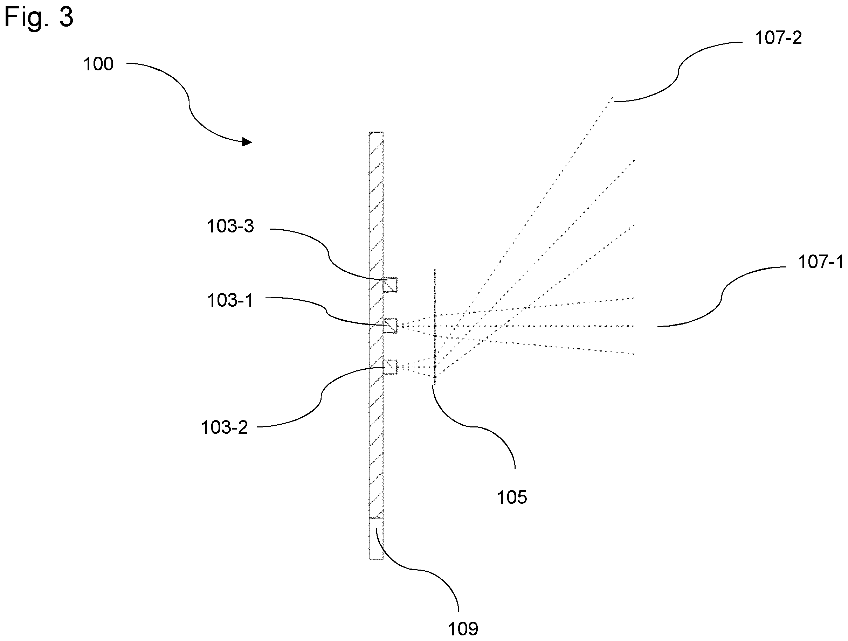

Fig. 3 zeigt eine weitere vergrößerte schematische Ansicht einer Anzeige 100 zum Anzeigen von Bildern oder Informationen. In diesem Fall sind die Lichtquellen 103-1 und 103-2 der jeweiligen Optikelemente 105 aktiviert, so dass das Bild oder die Information gleichzeitig in zwei Richtungen 107-1 und 107-2 angezeigt wird.

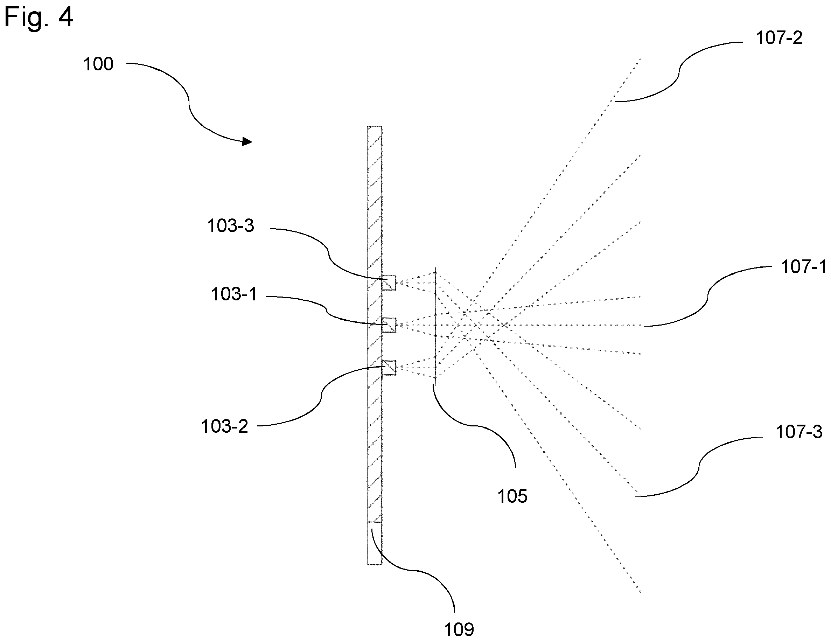

Fig. 4 zeigt eine weitere vergößerte schematische Ansicht einer Anzeige 100 zum Anzeigen von Bildern oder Informationen. In diesem Fall sind die Lichtquellen 103-1, 103-2 und 103-3 der jeweiligen Optikelemente 105 aktiviert, so dass das Bild oder die Information gleichzeitig in drei Richtungen 107-1, 107-2 und 107-3 angezeigt wird.

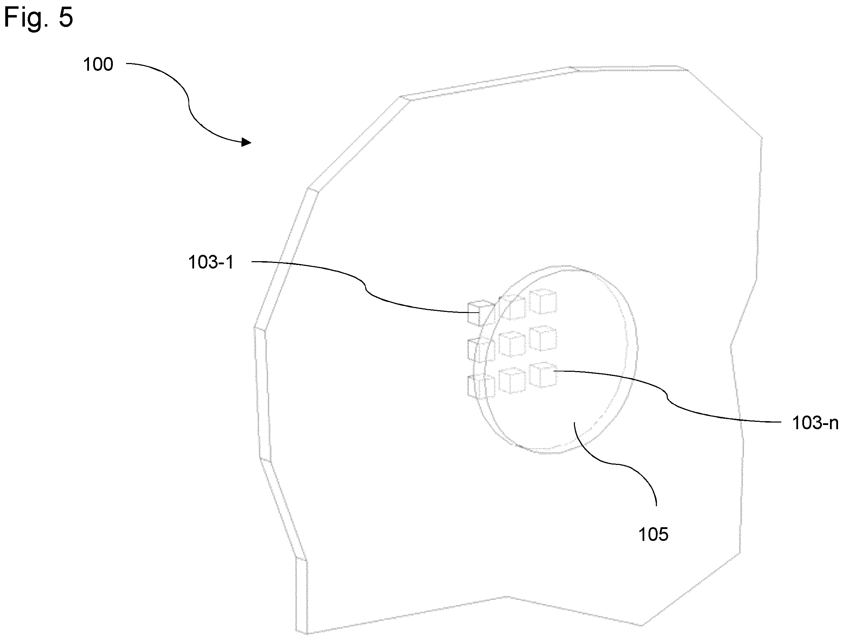

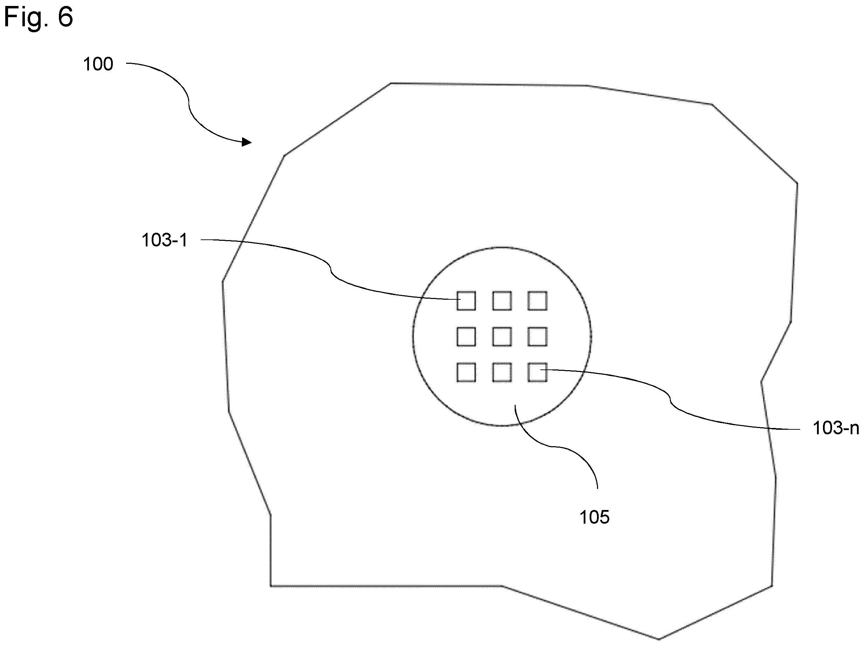

Fig. 5 und 6 zeigen eine weitere schematische Ansicht einer Anzeige 100 zum Anzeigen von Bildern oder Informationen. Hinter dem Optikelement 105 befindet sich eine zweidimensionale matrixförmige Anordnung von Lichtquellen 103-1, ..., 103-n. Die matrixförmige Anordnung von Lichtquellen 103-1, ..., 103-n kann durch einen LED-Bildschirm bereitgestellt werden.

Je nachdem welche Lichtquellen 103-1, ..., 103-n in den Optikelementen aktiviert werden, kann das Licht in eine der jeweiligen Lichtquellen 103-1, ..., 103-n zugeordnete Richtung projiziert werden.

Da sich die Lichtquellen 103-1 bis 103-n in matrixförmiger Anordnung hinter dem Optikelement 105 befinden, kann das angezeigte Bild oder die Information nicht nur in unterschiedlichen vertikalen Richtungen, sondern auch unterschiedlichen horizontalen Richtungen oder Kombinationen aus beiden Richtungen angezeigt werden.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Alle Verfahrensschritte können durch Vorrichtungen implementiert werden, die zum Ausführen des jeweiligen Verfahrensschrittes geeignet sind. Alle Funktionen, die von gegenständlichen Merkmalen ausgeführt werden, können ein Verfahrensschritt eines Verfahrens sein.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Anzeige
- 103: Lichtquellen
- 105: Optikelement
- 107: Richtung
- 109: Hintergrundplatte

## Patentansprüche

1. Anzeige (100) zum Anzeigen von veränderlichen Informationen, mit:
einer Mehrzahl von Lichtquellen (103-1, ..., 103-n); und
einem Optikelement (105) zum Lenken von Licht einer ersten Lichtquelle (103-1) in eine erste Richtung (107-1) und zum Lenken von Licht einer zweiten Lichtquelle (103-2) in eine zweite Richtung (107-2).

2. Anzeige (100) nach Anspruch 1, wobei die Lichtquellen (103-1, ..., 103-n) in einer Matrix angeordnet sind.

3. Anzeige (100) nach einem der vorangehenden Ansprüche, wobei die Lichtquellen (103-1, ..., 103-n) durch Mikro-LEDs oder organische LEDs gebildet sind.

4. Anzeige (100) nach einem der vorangehenden Ansprüche, wobei die Anzeige (100) eine Mehrzahl von Optikelementen (105) mit jeweils einer Mehrzahl von Lichtquellen (103-1, ..., 103-n) umfasst.

5. Anzeige (100) nach Anspruch 4, wobei die Optikelemente (105) matrixförmig angeordnet sind.

6. Anzeige (100) nach einem der vorangehenden Ansprüche, wobei die Lichtquellen (103-1, ..., 103-n) ausgebildet sind, Licht unterschiedlicher Wellenlänge zu emittieren.

7. Anzeige (100) nach einem der vorangehenden Ansprüche, wobei das Optikelement (105) eine Sammellinse, eine Freiformlinse und/oder ein Lichtleitelement umfasst.

8. Anzeige (100) nach einem der vorangehenden Ansprüche, wobei die Lichtquellen (103-1, ..., 103-n) einen Abstand von weniger als 300 um zueinander haben.

9. Anzeige (100) nach einem der vorangehenden Ansprüche, wobei das Optikelement (105) ausgebildet ist, Licht einer dritten Lichtquelle (103-3) in eine dritte Richtung (107-3) zu lenken.

10. Anzeige (100) nach einem der vorangehenden Ansprüche, wobei die Lichtquellen (103-1, ..., 103-n) auf einer Hintergrundplatte (109) der Anzeige (100) angeordnet sind.

11. Verfahren zum Anzeigen von Bildern oder Informationen, mit den Schritten:
- Lenken (S101) von Licht einer ersten Lichtquelle (103-1) durch ein Optikelement (105) in eine erste Richtung (107-1); und
- Lenken (S102) von Licht einer zweiten Lichtquelle (103-2) durch das Optikelement (105) in eine zweite Richtung (107-2).
